# EUROPEAN PATENT APPLICATION

(11) **EP 2 538 550 A1**
(43) Date of publication of application: **26.12.2012**
(21) Application number: 11832075.3
(22) Date of filing: 27.10.2011
(51) Int. Cl.: H03F 1/07, H03F 3/20

(54) **DOHERTY POWER AMPLIFIER DEVICE AND POWER AMPLIFICATION METHOD**

(30) Priority: 29.04.2011 CN 201110110871
(71) Applicant: ZTE Corporation, Shenzhen, Guangdong 518057 (CN)
(72) Inventor: CUI, Xiaojun, Shenzhen, Guangdong 518057 (CN); CHEN, Huazhang, Shenzhen, Guangdong 518057 (CN); DUAN, Bin, Shenzhen, Guangdong 518057 (CN); LIU, Jianli, Shenzhen, Guangdong 518057 (CN)
(74) Representative: Novagraaf Technologies
(86) International application number: PCT/CN2011/081412
(87) International publication number: WO 2012/146009

(57) **Abstract**

The present invention discloses a Doherty power amplifier apparatus and a power amplification method. The apparatus includes an auxiliary power amplifier apparatus and a main power amplifier apparatus, the auxiliary power amplifier apparatus is used to amplify signal power by adopting a Laterally Diffused Metal Oxide Semiconductor (LDMOS) device; and the main power amplifier apparatus is used to amplify signal power by adopting a High Electron Mobility Transistors (HEMT) device. The present invention adopts the HEMT device as the main power amplifier. Compared with the existing Doherty power amplifier in which both the main power amplifier and the auxiliary power amplifier adopt LDMOS, with the present invention, the power amplifier efficiency of the main power amplifier in the Doherty power amplifier can be enhanced, thereby making the power amplifier efficiency of the whole Doherty power amplifier be substantially increased.

## Description

### Technical Field

The present invention relates to the field of a radio frequency power amplifier design technology field, and particularly to a Doherty power amplifier apparatus and a power amplification method.

### Background of the Related Art

In the face of increasingly fierce competition in the market, efficiency of base station products has been become an important reference point for competition in the industry, and in the base station, efficiency advance of a main component which decides the efficiency, i.e., a power amplifier device, also becomes a core point; and in the industry a lot of manpower and material resources is invested to perform the research of efficiency advance technology. At present, the most widely used technology comprises the Doherty technology. Power amplifier manufactures have begun a mass production and application of the Doherty power amplifiers, and how to further enhance the efficiency in that technology also becomes particularly important.

The Doherty technology is originally applied to a traveling-wave tube, to provide a high-power transmitter for broadcast, and the architecture is simple, easy to implementation and high efficient.

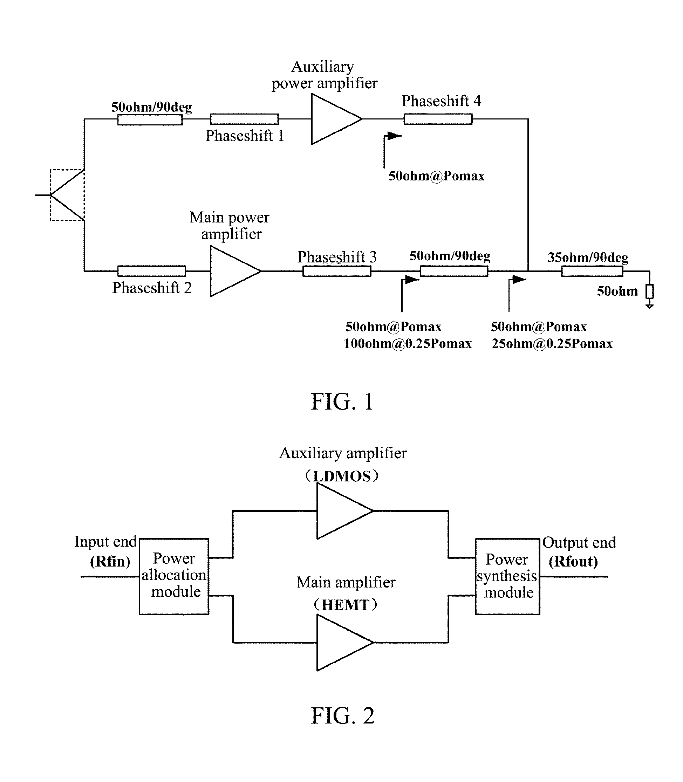

A traditional Doherty structure is composed of two power amplifiers: a main power amplifier (also called as carrier power amplifier) and an auxiliary power amplifier (also called as peak power amplifier), wherein the main power amplifier works in class B or class AB, and the auxiliary power amplifier works in class C. The two power amplifiers do not work by turns, in fact the main power amplifier works all along and the auxiliary power amplifier starts to work at a set peak value (so the auxiliary power amplifier is also called as the peak power amplifier). 90 degrees quarter wavelength line behind the output end of the main power amplifier plays a role in impedance transformation, the purpose of which is to play a role in reducing apparent impedance of the main power amplifier when the auxiliary power amplifier is working, thereby ensuring that active load impedance composed of the working auxiliary power amplifier and a subsequent circuit becomes low, and thus output current of the main power amplifier becomes large. Due to the quarter wavelength line behind the output end of the main power amplifier, a 90° phase shift is also required in front of the auxiliary power amplifier in order to make outputs of the two power amplifiers inphase, as shown in FIG. 1.

The main power amplifier works in the class B, when a total input signal is smaller, only the main power amplifier is in a working state; when an output voltage of the main power amplifier tube reaches a peak value saturation point, theoretic efficiency of the power amplifier can reach 78.5%. If excitation doubles here, then the saturation occurs when the main power amplifier reaches a half of the peak value, and the efficiency of the power amplifier also reaches the maximum value of 78.5%; and now the auxiliary power amplifier starts to work with the main power amplifier together. An introduction of the auxiliary power amplifier makes the load decrease from the point of view of the main power amplifier, because the role of the auxiliary power amplifier on the load is equivalent to connecting a negative impedance in series; therefore, even though the output voltage of the main power amplifier is saturated and constant, the output power continues to increase because of decreasing of the load (current flowing through the load increases). When the peak value of the excitation is reached, the auxiliary power amplifier reaches the maximum point of its own efficiency, such that the efficiency combining the two power amplifiers together is much higher than the efficiency of a single power amplifier of class B. The maximum efficiency, 78.5%, of the single power amplifier with class B appears at the peak value, while at present the efficiency of 78.5% appears at half of the peak value, so such system structure can reach a very high efficiency (each amplifier reaches the maximum output efficiency).

Both the main power amplifier and the peak power amplifier (auxiliary power amplifier) in the Doherty amplifiers adopt the same type of power amplifier tube, and the most type adopted in the industry is a Laterally Diffused Metal Oxide Semiconductor (LDMOS for short) device. By adopting the same type of power amplifier tube, the supply voltage and bias mode of the power amplifiers are the same, so a biasing circuit is easy to be designed; a mass production of the power amplifier tubes is relatively easy to control because the power amplifier tubes are the same type. Mainstream LDMOS device in the industry has been developed to the 8th generation, it has a low cost, but the upgrade space of performance is very limited, and meanwhile requirements for green environmental protection cannot be satisfied also.

### Summary of the Invention

The technical problem to be solved by the present invention is to provide a Doherty power amplifier apparatus and a power amplification method, to enhance the power amplifier efficiency of the Doherty power amplifier apparatus.

In order to solve the above technical problem, the present invention provides a Doherty power amplifier apparatus, comprising an auxiliary power amplifier apparatus and a main power amplifier apparatus, wherein, the auxiliary power amplifier apparatus is configured to adopt a Laterally Diffused Metal Oxide Semiconductor (LDMOS) device to amplify signal power; the main power amplifier apparatus is configured to adopt a High Electron Mobility Transistor (HEMT) device to amplify signal power.

The apparatus may also have the following characteristic:
the HEMT device is a based-on-GaN device.

In order to solve the above problem, the present invention also provides a power amplification method, comprising: in a Doherty power amplifier apparatus, adopting a Laterally Diffused Metal Oxide Semiconductor (LDMOS) device to amplify signal power of an auxiliary power amplifier apparatus, and adopting a High Electron Mobility Transistor (HEMT) device to amplify signal power of a main power amplifier apparatus.

The method may also have the following characteristic:
the HEMT device is a based-on-GaN device.

The method may also have the following characteristic:
selecting the HEMT device according to power amplifier parameters of the Doherty power amplifier apparatus.

In order to solve the above problem, the present invention also provides a main power amplifier apparatus, applied in a Doherty power amplifier apparatus, wherein, the main power amplifier apparatus is configured to adopt a High Electron Mobility Transistor (HEMT) device to amplify signal power.

The main power amplifier apparatus may also have the following characteristic:
the HEMT device is a based-on-GaN device.

In order to solve the above problem, the present invention also provides a power amplification method, comprising: in a Doherty power amplifier apparatus, adopting a High Electron Mobility Transistor (HEMT) device to amplify signal power of a main power amplifier apparatus.

The method may also have the following characteristic:
the HEMT device is a based-on-GaN device.

The method may also have the following characteristic of:
selecting the HEMT device according to power amplifier parameters of the Doherty power amplifier apparatus.

The above scheme adopts the HEMT device as the main power amplifier, and compared with the existing Doherty power amplifier in which both the main power amplifier and the auxiliary power amplifier adopt the LDMOS, the power amplifier efficiency of the main power amplifier in the Doherty power amplifier can be enhanced, thereby enhancing substantially the power amplifier efficiency of the whole Doherty power amplifier.

At present, the cost of the GaN power amplifier tube is 5-10 times higher than the cost of the LDMOS based on Si, so, compared with the Doherty power amplifier in which both the main power amplifier and the auxiliary power amplifier adopt the GaN, the cost will be reduced sharply while the performance is enhanced in the above method and apparatus.

In addition, because the development of LDMOS is very mature, products of each manufacturer are more complete, and there are varied types of products with different frequency bands and different power levels, during using, the LDMOS products with different model numbers may be acted as the Peak amplifiers according to different power levels, which are combined with the Carrier amplifier with GaN power amplifier tube, to realize the apparatus by adopting different Doherty structures (symmetrical structure, asymmetrical structure, multi-path structure, and so on) as required, so that not only the cost and performance are taken into account, but also the convenience and flexibility of use are ensured.

### Brief Description of Drawings

FIG. 1 is a structure diagram of a traditional Doherty power amplifier;
FIG. 2 is a structure diagram of a Doherty power amplifier with a two-path structure according to an embodiment;

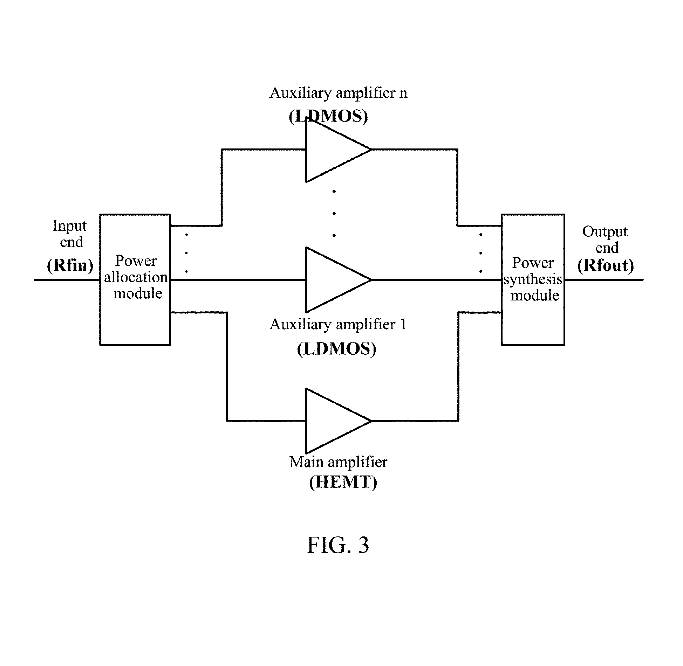

FIG. 3 is a structure diagram of a Doherty power amplifier with a multi-path structure according to an embodiment.

### Preferred Embodiments of the Present Invention

From a view of signal power spectrum distribution of different standards in the current communication system, 70%-80% energy output by a power amplifier is concentrated nearby an average power, that is, most of the working current of the power amplifier is contributed by a main power amplifier, therefore enhancing the efficiency of the main power amplifier is of great significance for the efficiency advance of the whole power amplifier.

A main power amplifier apparatus in the Doherty power amplifier according to an embodiment of the present invention is configured to adopt a High Electron Mobility Transistor (HEMT for short) device to amplify signal power.

The HEMT device is a based-on-GaN device.

A corresponding power amplification method comprises: in a Doherty power amplifier apparatus, adopting an HEMT device to amplify signal power of a main power amplifier apparatus. The HEMT device is a based-on-GaN device.

The HEMT device is selected according to power amplifier parameters of the Doherty power amplifier apparatus. The power amplifier parameters of the Doherty power amplifier apparatus comprise: working frequency, power value and peak-to-average power ratio.

The Doherty power amplifier apparatus according to the embodiment of the present invention comprises an auxiliary power amplifier apparatus and a main power amplifier apparatus. The auxiliary power amplifier apparatus is configured to adopt an LDMOS device to amplify signal power; the main power amplifier apparatus is configured to adopt an HEMT device to amplify signal power.

The HEMT device is a based-on-GaN device.

A corresponding power amplification method comprises: in a Doherty power amplifier apparatus, adopting an LDMOS device to amplify signal power of an auxiliary power amplifier apparatus, and adopting an HEMT device to amplify signal power of a main power amplifier apparatus. The HEMT device is a based-on-GaN device.

For a two-path Doherty power amplifier (including a traditional two-path symmetrical Doherty/asymmetrical Doherty structure) and a structure including a main amplifier and an auxiliary amplifier evolved on the above basis, an HEMT power amplifier tube is acted as the main amplifier, and an LDMOS power amplifier tube is acted as the auxiliary amplifier.

For a multi-path Doherty power amplifier and a structure including a main amplifier and multiple auxiliary amplifiers evolved on the above basis, an HEMT power amplifier tube is acted as the main amplifier, and LDMOS power amplifier tubes are acted as the auxiliary amplifiers.

The HEMT device is selected according to the power amplifier parameters of the Doherty power amplifier apparatus. the power amplifier parameters of the Doherty power amplifier apparatus comprise: the working frequency, the power value and the peak-to-average power ratio.

In designing of the Doherty power amplifier, the model number of the HEMT power amplifier tube used by the main amplifier is determined according to the required power amplifier parameters; the structure of the Doherty power amplifier is determined (two-path or multi-path structure), and the model number of the LDMOS power amplifier tube used by the auxiliary power amplifier is determined; a matching design of the amplifiers and a design of parts of power allocation, power synthesis in a block diagram are completed; and a design of remaining parts of the Doherty power amplifier is completed.

A Doherty power amplifier apparatus applied in the embodiment of the present invention comprises a power allocation module and a power synthesis module. The power allocation module is responsible for a function of allocating input signals to the main power amplifier and the auxiliary power amplifier respectively, and regarding to the traditional Doherty power amplifier as shown in FIG. 1, the power allocation module comprises the component portion between an input end of the auxiliary power amplifier and an input end of the main power amplifier to an input end of the whole Doherty power amplifier. The power synthesis module is responsible for a function of synthesizing an amplified signal output by the main power amplifier and an amplified signal of the auxiliary power amplifier, and for the traditional Doherty power amplifier as shown in FIG. 1, the power synthesis module comprises the component portion between an output end of the auxiliary power amplifier and an output end of the main power amplifier to an output end (RFout) of the whole Doherty power amplifier. The power allocation module and the power synthesis module are not limited to the structure of the traditional Doherty power amplifier as shown in FIG. 1, and respectively correspond to a circuit layout that executes the corresponding power allocation function and a circuit layout that executes the corresponding power synthesis function in Doherty power amplifiers with other structures which are suited to the embodiment of the present invention.

Specific application example:

For a design of a Doherty power amplifier with a power of 85W and a peak-to-average power ratio of 6dB which is applied in a 2.1GHz UMTS system, two power amplifier tubes with saturation power more than at least 360W are required. In combination with existing devices of the power amplifier tube manufacturer, it can be realized by using two LDMOS power amplifier tubes of 200W with the symmetrical Doherty structure, and in terms of the current device standards in the industry, the single-final-stage power amplifier efficiency thereof is about 52%; while, realizing with the method according to the embodiment of the present invention, the main amplifier uses an HEMT power amplifier tube of 200W, and the auxiliary amplifier uses an LDMOS power amplifier tube of 200W, thus the single-final-stage power amplifier efficiency thereof is about 55%, enhancing the power amplifier efficiency. If both the main amplifier and the auxiliary amplifier adopt the HEMT power amplifier tubes, the single-final-stage power amplifier efficiency is still about 55%, however the cost will be about 5-10 times higher than the implementation based on the method of the embodiment of the present invention.

A breakthrough, brand new combination mode is adopted in the embodiment of the present invention. By taking full advantage of high efficiency of the HEMT power amplifier tube, the HEMT power amplifier tube is acted as the main amplifier to enhance the efficiency and realize an optimal performance; meanwhile, by taking advantages of high technology maturity, low cost, complete device types of the LDMOS power amplifier tube, the LDMOS power amplifier tube is acted as the auxiliary amplifier to realize an optimal cost, and finally to realize a perfect combination of performance and cost. An efficiency index of the Doherty power amplifier could be enhanced significantly within the working frequency band range of the Doherty power amplifier, and the present apparatus can be widely applied in designs of various Doherty power amplifiers.

It should be noted that, in the case of no conflicting, embodiments in the present application and characteristics in the embodiments of the present application can be combined with each other in arbitrary way.

Of course, the present invention can have many other embodiments, and without departing from the spirit and essence of the present invention, those skilled in the art can make various corresponding changes and variations according to the present invention, however, those corresponding changes and variations should fall into the protection scope of appended claims of the present invention.

Those of ordinary skill in the art can understand that all or part of steps in the above-mentioned method can be completed by a program instructing relevant hardware, the program can be stored in a computer readable storage medium, such as a read only memory, a magnetic disk or a compact disk. Alternatively, the all or part of steps of the above-mentioned embodiments can also be implemented by using one or more integrated circuits. Correspondingly, each module/unit in the above-mentioned embodiments may be implemented in form of hardware, or may be implemented in form of software function module. The present invention is not limited to any specified form of the combination of hardware and software.

### Industrial Applicability

Compared with the existing Doherty power amplifier in which both the main power amplifier and the auxiliary power amplifier adopt LDMOS, the above-mentioned implementation can enhance the power amplifier efficiency of the main power amplifier in the Doherty power amplifier, thereby enhancing substantially the power amplifier efficiency of the whole Doherty power amplifier; the cost will be dropped sharply while the performance is enhanced; and not only the cost and performance are taken into account, but also the convenience and flexibility of use are ensured.

## Claims

1. A Doherty power amplifier apparatus, comprising an auxiliary power amplifier apparatus and a main power amplifier apparatus, wherein,
the auxiliary power amplifier apparatus is configured to adopt a Laterally Diffused Metal Oxide Semiconductor (LDMOS) device to amplify signal power;
the main power amplifier apparatus is configured to adopt a High Electron Mobility Transistor (HEMT) device to amplify signal power.

2. The apparatus according to claim 1, wherein,
the HEMT device is a based-on-GaN device.

3. A power amplification method, comprising:
in a Doherty power amplifier apparatus, adopting a Laterally Diffused Metal Oxide Semiconductor (LDMOS) device to amplify signal power of an auxiliary power amplifier apparatus, and adopting a High Electron Mobility Transistor (HEMT) device to amplify signal power of a main power amplifier apparatus.

4. The method according to claim 3, wherein,
the HEMT device is a based-on-GaN device.

5. The method according to claim 3, further comprising:
selecting the HEMT device according to power amplifier parameters of the Doherty power amplifier apparatus.

6. A main power amplifier apparatus, used for a Doherty power amplifier apparatus, wherein,
the main power amplifier apparatus is configured to adopt a High Electron Mobility Transistor (HEMT) device to amplify signal power.

7. The main power amplifier apparatus according to claim 6, wherein,
the HEMT device is a based-on-GaN device.

8. A power amplification method, comprising:
in a Doherty power amplifier apparatus, adopting a High Electron Mobility Transistor (HEMT) device to amplify signal power of a main power amplifier apparatus.

9. The method according to claim 8, wherein,
the HEMT device is a based-on-GaN device.

10. The method according to claim 8, further comprising:
selecting the HEMT device according to power amplifier parameters of the Doherty power amplifier apparatus.
